(19) Europäisches Patentamt
European Patent Office
Office européen des brevets

(11) EP 1 156 091 A1

(12) **EUROPÄISCHE PATENTANMELDUNG**

(43) Veröffentlichungstag:
**21.11.2001 Patentblatt 2001/47**

(51) Int Cl.⁷: $C09G\ 1/02$

(21) Anmeldenummer: **01111686.0**

(22) Anmeldetag: **14.05.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **16.05.2000 DE 10024874**

(71) Anmelder:
• **Infineon Technologies AG**
  **81669 München (DE)**
• **SIEMENS AKTIENGESELLSCHAFT**
  **80333 München (DE)**

(72) Erfinder:
• **Beitel, Gerhard, Dr.**
  **84453 Muehldorf/Inn (DE)**
• **Seebacher, Baerbel**
  **83607 Holzkirchen (DE)**
• **Saenger, Annette, Dr.**
  **01099 Dresden (DE)**

(74) Vertreter: **Ginzel, Christian et al**
**Zimmermann & Partner,**
**Postfach 33 09 20**
**80069 München (DE)**

(54) **Polierflüssigkeit und Verfahren zur Strukturierung von Metallen und Metalloxiden**

(57)     Die Erfindung beschreibt eine Polierflüssigkeit für einen chemisch-mechanischen Polier-Prozessschritt, die ein polykritallines Diamantpulver sowie zumindest ein Additiv aus der Gruppe Oxidationsmittel, Komplexbildner, Tenside und organische Basen enthält. Mit der erfindungsgemäßen Polierflüssigkeit kann die Abtragsrate für Metallschichten und Metalloxidschichten, welche insbesondere Elemente der Gruppe 8b des Periodensystems enthalten, erhöht werden.

Des weiteren beschreibt die Erfindung ein Verfahren zur Planarisierung und/oder Strukturierung einer Metall- oder Metalloxidschicht.

FIG 6

**Beschreibung**

Die Erfindung betrifft eine Polierflüssigkeit, die beispielsweise für das Planarisieren und/oder Strukturieren von Metall- und Metalloxidschichten auf einem Substrat durch einen chemisch-mechanischen Polierprozessschritt eingesetzt werden kann. Weiterhin betrifft die Erfindung ein Verfahren zum Planarisieren und/oder Strukturieren von Metallen und Metalloxiden.

Um die in einem Speicherkondensator einer Speicherzelle gespeicherte Ladung reproduzierbar auslesen zu können, sollte die Kapazität des Speicherkondensators mindestens einen Wert von etwa 30 fF besitzen. Gleichzeitig muß für die Entwicklung von DRAM Speicherzellen die laterale Ausdehnung des Kondensators ständig verkleinert werden, um weitere Erhöhungen der Speicherdichten erzielen zu können. Diese an sich gegenläufigen Anforderungen an den Kondensator der Speicherzelle führen zu einer immer komplexeren Strukturierung des Kondensators ("Trench-Kondensatoren", "Stack-Kondensatoren", "Kronen-Kondensatoren"). Dementsprechend wird die Herstellung des Kondensators aufwendiger und damit immer teurer.

Ein anderer Weg, ausreichende Kapazitäten der Speicherkondensatoren zu gewährleisten, liegt in der Verwendung von Materialien mit sehr hoher Dielektrizitätskonstante zwischen den Kondensatorelektroden. In letzter Zeit werden daher anstatt des herkömmlichen Siliziumoxids/ Siliziumnitrids neue Materialien, insbesondere hoch-$\varepsilon$ Paraelektrika und Ferroelektrika, als Dielektrikum verwendet, die eine deutlich höhere relative Dielektrizitätskonstante ( > 20) haben als das herkömmliche Siliziumoxid/Siliziumnitrid (< 8). Damit kann bei gleicher Kapazität die Kondensatorfläche und damit die benötigte Komplexität der Strukturierung des Kondensators deutlich vermindert werden. Wesentliche Vertreter dieser neuen Materialien mit hoher relativer Dielektrizitätskonstante sind Bariumstrontiumtitanat (BST, $(Ba,Sr)TiO_3$), Bleizirkonattitanat (PZT, $Pb(Zr,Ti)O_3$) bzw. Lanthan-dotiertes Bleizirkonattitanat und Strontiumwismuttantalat (SBT, $SrBi_2Ta_2O_9$).

Neben herkömmlichen DRAM-Speicherbausteinen werden in Zukunft auch ferroelektrische Speicheranordnungen, sogenannte FRAM's, eine wichtige Rolle spielen. Ferroelektrische Speicheranordnungen besitzen gegenüber herkömmlichen Speicheranordnungen, wie beispielsweise DRAMs und SRAMs, den Vorteil, dass die gespeicherte Information auch bei einer Unterbrechung der Spannungs- bzw. Stromversorgung nicht verloren geht, sondern gespeichert bleibt. Diese Nichtflüchtigkeit ferroelektrischer Speicheranordnungen beruht auf der Tatsache, dass bei ferroelektrischen Materialien die durch ein äußeres elektrisches Feld erzeugte Polarisation auch nach Abschalten des äußeren elektrischen Feldes im wesentlichen beibehalten wird. Auch für ferroelektrische Speicheranordnungen kommen die bereits genannten neuen Materialien wie Bleizirkonattitanat (PZT, $Pb(Zr,Ti)O_3$) bzw. Lanthan-dotiertes

Bleizirkonattitanat oder Strontium-Bismut-Tantalat (SBT, $SrBi_2Ta_2O_9$) zum Einsatz.

Leider bedingt die Verwendung der neuen Paraelektrika bzw. Ferroelektrika die Verwendung neuer Elektroden- und Barrierematerialien. Die neuen Paraelektrika bzw. Ferroelektrika werden üblicherweise auf bereits vorhandenen Elektroden (untere Elektrode) abgeschieden. Die Prozessierung erfolgt unter hohen Temperaturen, bei denen die Materialien, aus denen normalerweise die Kondensatorelektroden bestehen, so z.B. dotiertes Polysilizium, leicht oxidiert werden und ihre elektrisch leitenden Eigenschaften verlieren, was zum Ausfall der Speicherzelle führen würde.

Wegen ihrer guten Oxidationsbeständigkeit und/oder der Ausbildung elektrisch leitfähiger Oxide gelten 4d und 5d Übergangsmetalle, insbesondere Edelmetalle wie Ru, Rh, Pd, Os, Pt und insbesondere Ir bzw. $IrO_2$, als aussichtsreiche Kandidaten, die das dotierte Silizium/Polysilizium als Elektroden- und Barrierenmaterial ersetzen könnten.

Ein Problem ist, dass die oben genannten, in integrierten Schaltungen neu eingesetzten Elektroden- und Barrierenmaterialien zu einer Klasse von Materialien gehören, die sich nur schwer strukturieren lassen. Durch ihre chemische Inertheit sind sie nur schwer ätzbar, so dass der Ätzabtrag, auch bei der Verwendung "reaktiver" Gase, überwiegend oder fast ausschließlich auf dem physikalischen Anteil der Ätzung beruht. Beispielsweise wurde bisher Iridiumoxid in der Regel durch Trockenätzverfahren strukturiert. Ein wesentlicher Nachteil dieser Verfahren ist die durch den hohen physikalischen Anteil der Ätzung bedingte, fehlende Selektivität des Verfahrens. Dies hat zur Folge, dass durch die Erosion der Masken, die unvermeidlich geneigte Flanken haben, nur eine geringe Maßhaltigkeit der Strukturen gewährleistet werden kann. Darüber hinaus kommt es zu unerwünschten Re-Depositionen auf dem Substrat, auf der Maske oder in der genutzten Anlage.

Darüber hinaus erweisen sich diese Materialien auch bei der Verwendung von sogenannten CMP-Verfahren (chemical mechanical polishing) als äußerst widerstandsfähig. CMP-Standardverfahren zur Planarisierung und Strukturierung von Metalloberflächen existieren beispielsweise für Wolfram und Kupfer, sowie für die als Barriereschicht verwendeten Materialien wie Ti, TiN, Ta und TaN. Weiterhin Stand der Technik sind die CMP Prozesse zur Planarisierung von Polysilizium, Siliziumoxid und Siliziumnitrid. Die in diesen Verfahren verwendeten Polierflüssigkeiten sind jedoch nicht für das Abtragen von Edelmetallen geeignet. Das Problem eines CMP-Verfahrens für Edelmetalle und deren Oxide wie Pt, Ir oder $IrO_2$ besteht wiederum in deren chemischer Inertheit und schweren Oxidierbarkeit.

Des weiteren wurde bisher versucht, Edelmetalle wie Platin mit Hilfe von wäßriger Suspensionen monokristalliner Nanopartikel(d.h. Partikeln mit einer Größe von unter 1 μm) zu polieren. Als Nanopartikel wurden dabei z.B. $SiO_2$ und $Al_2O_3$ eingesetzt, siehe

hierzu J. Haisma et al., Philips J. Res. 49 (1995), 23-46. Der Poliervorgang erfolgt hierbei hauptsächlich durch mechanischen Abtrag. Um ein Aggregieren der Schleifpartikel und damit eine Kratzerbildung zu vermeiden werden organische Flüssigkeiten, wie z.B. Glycerin oder Polyalkohole, zugesetzt. Nachteilig an den bekannten Polierflüssigkeiten sind die geringen Abtragsraten, die damit erreicht werden können. Eigene Versuche mit $SiO_2$ und $Al_2O_3$ als Abrasivteilchen haben gezeigt, dass nur bei hohem Abrasivgehalt der Suspension ein geringer Abtrag erreicht werden kann. Bei geringem Abrasivgehalt (in der Größenordnung von Slurries, die für herkömmliche Oxid- und Wolfram-CMP-Prozesse verwendet werden) konnte überhaupt kein Abtrag festgestellt werden. Darüber hinaus bilden sich Kratzer, die u.a. durch ein Agglomerieren der Abrasivteilchen entstehen können. Die erprobten Teilchengrößen bewegen sich im Bereich von 50 bis 200 nm.

Der vorliegenden Erfindung liegt daher die Aufgabe zugrunde, eine Polierflüssigkeit bereitzustellen, die für die Planarisierung bzw. Strukturierung von Metallen und Metalloxiden eingesetzt werden kann und die eine hinreichend hohe Abtragsrate gewährleistet.

Diese Aufgabe wird von der Polierflüssigkeit gemäß dem Patentanspruch 1 gelöst. Weiterhin wird ein Verfahren zur Planarisisierung und/oder Strukturieren einer Metalloxidschicht nach dem Patentanspruch 9 bereitgestellt. Weitere vorteilhafte Ausführungsformen, Ausgestaltungen und Aspekte der vorliegenden Erfindung ergeben sich aus den abhängigen Patentansprüchen, der Beschreibung und den Ausführungsbeispielen.

Erfindungsgemäß wird eine Polierflüssigkeit, insbesondere für das Abtragen und/oder Strukturieren von Metalloxiden und Metallen, insbesondere Elementen der Gruppe 8b des Periodensystems, durch chemisch-mechanisches Polieren, bereitgestellt, welche

    a) Wasser oder ein Wasser/Alkoholgemisch,

    b) polykristallines Diamantpulver, und

    c) zumindest ein Additiv ausgewählt aus der Gruppe Oxidationsmittel, Komplexbildner, Tensid und organische Base

enthält.

Die erfindungsgemäße Polierflüssigkeit enthält als flüssige Phase Wasser oder ein Wasser/Alkohol-Gemisch. Durch diese flüssige Phase wird eine optimale Benetzung der Polierscheibe einerseits und der zu polierenden Oberfläche (z.B. Wafer) andererseits gewährleistet.

Ferner enthält die erfindungsgemäße Polierflüssigkeit polykristallines Diamantpulver, dessen Partikelgröße vorzugsweise unter etwa 1 μm liegt, insbesondere zwischen 0,05 und 1 μm, und speziell zwischen 0,1 und 1 μm. Als besonders geeignet hat sich synthetisch hergestelltes polykristallines Diamantpulver herausgestellt. Trotz des relativ großen Partikeldurchmessers der Diamantteilchen ist es mit der erfindungsgemäßen Polierflüssigkeit möglich, sehr glatte Oberflächen herzustellen. Bei einem typischen Polierverfahren konnten mit einer Polierflüssigkeit, die 1 μm große, synthetische Diamantpartikel enthielt, eine Oberflächenrauhigkeit von 3,5 nm (rms, gemessen mit der Analysenmethode AFM) bei einer maximalen Tiefe einzelner Kratzer von 20 nm erzielt werden. Eine Erklärung für die relativ glatten Oberflächen, die mit der erfindungsgemäßen Polierflüssigkeit erzielt werden können, ist, dass die polykristallinen Diamantteilchen unter mechanischer Belastung (Polierdruck) leicht in kleinere Teilchen zerfallen, wodurch eine entsprechend geringe Kratzertiefe bewirkt wird.

Durch die in der erfindungsgemäßen Polierflüssigkeit enthaltenen polykristallinen Diamantpartikel wird, wie vorstehend beschrieben, ein mechanischer Abtrag ohne Ausbildung tiefer Kratzer auf der zu polierenden Oberfläche erreicht. Durch die Zugabe von Additiven wird des weiteren ein chemischer Abtrag auf einer Metall- bzw. Metalloxidoberfläche bewirkt. Die Additive sind besonders wirksam, wenn sie in Zusammenhang mit Oberflächen eingesetzt werden, die Edelmetalle, wie Elemente der Gruppe 8b des Periodensystems der Elemente, enthalten oder aus diesen bestehen. Zu den vorgenannten Edelmetallen gehören Ruthenium (Ru), Rhodium (Rh), Palladium (Pd), Osmium (Os), Iridium (Ir) und Platin (Pt).

Eine erste Gruppe von Additiven, die mit Vorteil in der erfindungsgemäßen Polierflüssigkeit eingesetzt werden kann, sind Oxidationsmittel, insbesondere starke Oxidationsmittel wie Sauerstoff, $O_3$, $H_2O_2$ oder Peroxodisulfat in saurer oder alkalischer Lösung, Chlor-Sauerstoffverbindungen wie z.B. Hypochlorit, Chlorat und Perchlorat, Brom-Sauerstoffverbindungen wie z.B. Bromat, Jod-Sauerstoffverbindungen wie z.B. Jodat, Mangan-Sauerstoffverbindungen wie z.B. Permanganat, Chrom-Sauerstoffverbindungen wie z.B. Chromat, Eisen(III)-Verbindungen wie z.B. $Fe_2(SO_4)$, $K_3Fe(CN)_6$ und $Fe(A)_3$ mit A = F, Cl, Br, J, oder $(NO_3)$, Cer(IV)-Verbindungen wie z.B. $Ce(SO_4)_2$ und $Ce(NO_3)_4$, Königswasser und Chromschwefelsäure, wobei die vorgenannten Oxidationsmittel allein oder in Kombination verwendet werden können. Durch den Einsatz der Oxidationsmittel entstehen Oxidschichten an der Oberfläche der zu behandelnden Metalle, wodurch ein weiteres Oxidieren bzw. die Auflösung des zu polierenden Metalls verhindert werden kann. Diese durch das Oxidationsmittel bewirkte Passivierung der Oberfläche wird durch mechanischen Abrieb wieder beseitigt, so dass wieder "frische", d.h. nicht oxidierte Metalloberfläche mit der oxidierenden Lösung in Kontakt treten kann. Die Abfolge Oxidierung/Entfernung der oxidierten Schicht wird dann so oft wiederholt, bis der gewünschte Abtrag erreicht worden ist.

Es ist jedoch auch denkbar, dass bei chemisch-mechanisch Polierverfahren zunächst ein mechanischer Abtrag und dann eine chemische Oxidation erfolgt, d.h. der mechanische Abtrag dem chemischen vorgeschaltet ist. Vor allem bei Edelmetallen ist diese Reihenfolge sogar nicht unwahrscheinlich, da rauhe 0berflächen sowie kleine Cluster leichter oxidiert werden können. Außerdem bilden einige Metalle, wie z.B. Pt, keine passivierende Oxidschicht.

Eine zweite Gruppe von Additiven, die günstigerweise zusammen mit dem polykristallinen Diamantpulver eingesetzt werden kann, sind Komplexbildner. Dabei sind im einzelnen zwei verschiedene Wirkungsweisen von Komplexbildnern zu unterscheiden.

Zunächst einmal können Komplexbildner eingesetzt werden, die durch Komplexierung von Edelmetallionen das Normalpotential von Edelmetallen soweit senken, dass ein Angriff durch Oxidationsmittel möglich wird. Ein Beispiel dafür wäre die Reaktion

$$Pt^{2+} + 4\ Cl^- \rightarrow [PtCl_4]^{2-},$$

bei der das Normalpotential $E_0$ von +1,2 V auf +0,73 V gesenkt wird. Durch die Zugabe geeigneter Komplexbildner wird das Gleichgewicht zwischen Edelmetall in elementarer Form und seinen Ionen in der Lösung zugunsten der Neubildung von Ionen (z.B. $Pt^{2+}$) verschoben. Das Oxidationspotential des Edelmetalls in der Lösung wird durch die Wirkung der Komplexierung abgesenkt, so wie das z.B. bei der Auflösung metallischen Goldes durch Cyanidlauge geschieht. Bei einem Edelmetall mit erniedrigtem Oxidationspotential ist eine chemisch-mechanische Politur schneller abgeschlossen, weil eine Reaktion der Oberfläche sowie abgetragener Teilchen des Edelmetalls mit dem eingesetzten Oxidationsmittel schneller abläuft oder erst ermöglicht wird im Vergleich zu Polierverfahren, bei denen kein Komplexbildner zum Einsatz kommt. Ferner wird der Einsatz von schwächeren, weniger aggressiven Oxidationsmitteln möglich. Dies wirkt sich u.U. vorteilhaft auf die Lebensdauer von Anlagen sowie Arbeitsschutzmaßnahmen aus.

Komplexbildner mit diesem Wirkungsmechanismus sind z. B. Chelatliganden in basischer Lösung. Darunter fallen EDTA (Ethylendiamintetraessigsäure), stickstoffhaltige Kronenether wie 1,4,8,11-Tetraazacyclotetradecan-Derivate(erhältlich von Fluka unter #86771 oder #86733) und Zitronensäure. Auch einfache Chlorid-, Bromid- oder Cyanidliganden (z.B. in Form ihrer Alkalisalze) können einen entsprechenden Effekt bewirken.

Eine zweite Art von Komplexbildnern wird eingesetzt, um z.B. eine Re-Deposition des von der Oberfläche mechanisch entfernten Materials (z.B. Pt) und/oder eine Kratzerbildung zu verhindern. Kratzer können durch mechanische Einwirkung größerer Partikel auf die zu bearbeitende Oberfläche entstehen. Diese größeren Partikel wiederum entstehen durch Agglomeration von mechanisch abpoliertem Material sowie eventuell Partikeln des Schleifmaterials. Eine derartige Re-Deposition sowie Agglomeration kann durch eine Komplexierung von Edelmetallatomen oder Clustern verhindert werden. Beispiele für entsprechende Komplexbildner sind metallorganische Koordinationsverbindungen auf der Basis von Phosphinliganden ($PR_3$, R = organischer Rest), welche stabile Edelmetallkomplexe (z.B. Pt-Komplexe) bilden.

Schließlich kann mit Vorteil eine dritte Gruppe von Additiven zusammen mit den polykristallinen Diamantpartikeln in der erfindungsgemäßen Polierflüssigkeit eingesetzt werden. Diese dritte Gruppe sind z.B. Tenside oder organische Basen, welche die Oberflächenspannung der Polierflüssigkeit herabsetzen sowie die Benetzung der zu polierenden Oberfläche mit Polierflüssigkeit verbessern. Durch die Verringerung der Oberflächenspannung wird u.a. die Entfernung von Metallpartikeln von der zu bearbeitenden Oberfläche sowie von Schleifpartikeln und Poliertuchresten erleichtert.

Wie bereits erwähnt sind die Partikel in der Polierflüssigkeit vorzugsweise Nanopartikel, also Partikel mit einem mittleren Durchmesser kleiner als etwa 1 μm. Weiterhin ist es bevorzugt, wenn der Anteil der abrasiven Partikel (Diamantpulver) in der Polierflüssigkeit zwischen 1 und 30 Gewichtsprozent beträgt.

Erfindungsgemäß wird auch ein Verfahren zur Planarisierung und/oder Strukturieren einer Metalloxidschicht oder Metallschicht, enthaltend Metalle der Gruppe 8b des Periodensystems, bereitgestellt, das die folgenden Schritte aufweist:

a) ein Substrat wird bereitgestellt,

b) eine Metalloxidschicht oder eine Metallschicht wird aufgebracht,

c) eine Polierflüssigkeit enthaltend polykristallines Diamantpulver wird bereitgestellt, und

d) die Metalloxidschicht oder die Metallschicht wird durch einen Polierschritt mit Hilfe der Polierflüssigkeit planarisiert und/oder strukturiert.

Das erfindungsgemäße Verfahren besitzt den Vorteil, dass damit unstrukturierte edelmetallhaltige Oberflächen enthaltend Elemente der Gruppe 8b des Periodensystems der Elemente mit hohen Abtragsraten strukturiert und/oder planarisiert werden können.

Bei dem erfindungsgemäßen Verfahren werden vorzugsweise polykristalline Diamantpulver im Nanobereich, d.h. mit einer Partikelgröße von unter etwa 1 μm, eingesetzt. Besonders geeignet sind polykristalline Diamantpartikel mit einer Größe zwischen 0,05 und 1 μm, insbesondere zwischen 0,1 und 1 μm. Als besonders günstig hat es sich erwiesen, synthetisches, polykristallines Diamantpulver einzusetzen. Die Menge des polykristallinen Diamantpulvers in der Polierflüssigkeit, die bei dem erfindungsgemäßen Verfahren eingesetzt wird, beträgt vorzugsweise 1 bis 30 Gewichtsprozent.

Für chemisch-mechanische Polierverfahren (CMP) ist es des weiteren von Vorteil, wenn der Polierflüssigkeit Additive zugesetzt werden, welche die chemische Komponente des Polierverfahrens unterstützen. Geeignete Additive sind die bereits vorstehend näher beschriebenen Oxidationsmittel (z.B. Sauerstoff, $O_3$, $H_2O_2$, Peroxodisulfat in saurer oder alkalischer Lösung, Chlor-Sauerstoffverbindungen wie z.B. Hypochlorit, Chlorat und Perchlorat, Brom-Sauerstoffverbindungen wie z.B. Bromat, Jod-Sauerstoffverbindungen wie z.B. Jodat, Mangan-Sauerstoffverbindungen wie z.B. Permanganat, Chrom-Sauerstoffverbindungen wie z.B. Chromat, Eisen(III)-Verbindungen wie z.B. $Fe_2(SO_4)_3$, $K_3Fe(CN)_6$ und $Fe(A)_3$ mit A = F, Cl, Br, J oder $(NO_3)$, Cer(IV)-Verbindungen wie z.B. $Ce(SO_4)_2$ und $Ce(NO_3)_4$, Königswasser und Chromschwefelsäure, wobei die vorgenannten Oxidationsmittel allein oder in Kombination eingesetzt werden können), Komplexbildner (z. B. EDTA, stickstoffhaltige Kronenether, Zitronensäure, Chloridliganden, Bromidliganden, Cyanidliganden und metallorganische Koordinationsverbindungen auf der Basis von Phosphinliganden ($PR_3$, wobei R einen organischen Rest darstellt)) und Tenside bzw. organische Basen.

Der Polierdruck kann bei dem erfindungsgemäßen Verfahren vorzugsweise zwischen etwa 3,45 und 69 kPa (0,5 und 10 psi), insbesondere zwischen 6,9 und 34,5 kPa (1 bis 5 psi) eingestellt werden. Die damit erzielbaren Abtragsraten liegen bei einer Größe der polykristallinen Diamantpartikel von etwa 1 μm im Bereich zwischen 5 und 60 nm/min, insbesondere zwischen 20 und 50 nm/min.

Die Rotationsgeschwindigkeit der Polierscheibe beträgt vorzugsweise zwischen 20 und 70 Umdrehungen/min (rpm). Die übliche Polierdauer liegt zwischen etwa 2 und 10 min, insbesondere bei zwischen etwa 3 und 5 min.

Die Erfindung wird nachfolgend anhand von Figuren der Zeichnung näher dargestellt. Es zeigen:

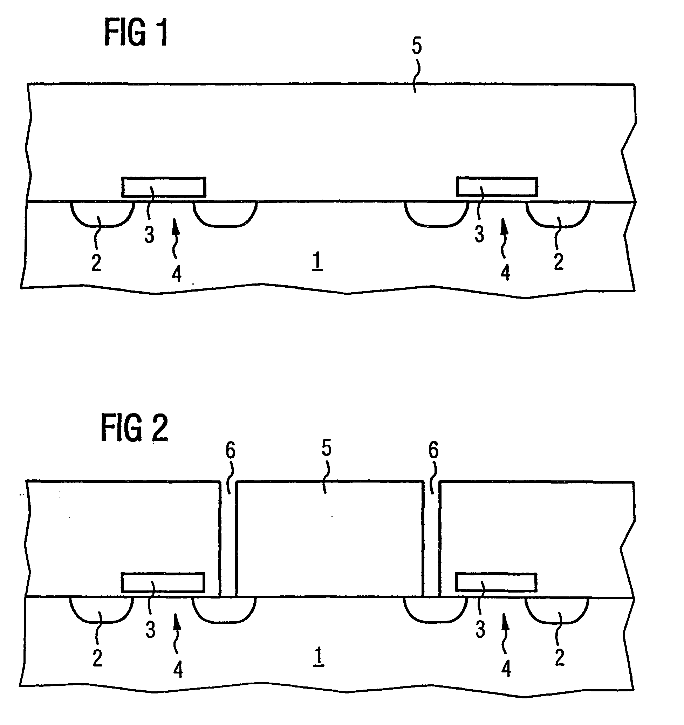

Fig. 1 - 6     ein Verfahren zur Planarisierung und/ oder Strukturierung einer Metalloxidschicht bzw. einer Metallschicht gemäß einer Ausführungsform der vorliegenden Erfindung.

Fig. 1 zeigt ein Siliziumsubstrat 1 mit bereits fertiggestellten Transistoren 4. Die Transistoren bilden mit den noch herzustellenden Speicherkondensatoren die Speicherzellen, die der Speicherung der binären Informationen dienen. Die Transistoren 4 weisen jeweils zwei Diffusionsgebiete 2 auf, welche an der Oberfläche des Siliziumsubstrats 1 angeordnet sind. Zwischen den Diffusionsgebieten 2 der Transistoren 4 sind die Kanalzonen angeordnet, die durch das Gateoxid von den Gateelektroden 3 auf der Oberfläche des Siliziumsubstrats 1 getrennt sind. Die Transistoren 4 werden nach den im Stand der Technik bekannten Verfahren hergestellt, die hier nicht näher erläutert werden.

Auf das Siliziumsubstrat 1 mit den Transistoren 4 wird eine isolierende Schicht 5, beispielsweise eine $SiO_2$-Schicht aufgebracht. In Abhängigkeit des für die Herstellung der Transistoren 4 verwendeten Verfahrens können auch mehrere isolierende Schichten aufgebracht werden. Die sich daraus ergebende Struktur ist in Fig. 1 gezeigt.

Anschließend werden durch eine Phototechnik die Kontaktlöcher 6 erzeugt. Diese Kontaktlöcher 6 stellen eine Verbindung zwischen den Transistoren 4 und den noch zu erzeugenden Speicherkondensatoren her. Die Kontaktlöcher 6 werden beispielsweise durch eine anisotrope Ätzung mit fluorhaltigen Gasen erzeugt. Die sich daraus ergebende Struktur ist in Fig. 2 gezeigt.

Nachfolgend wird ein leitfähiges Material 7, beispielsweise insitu dotiertes Polysilizium, auf die Struktur aufgebracht.

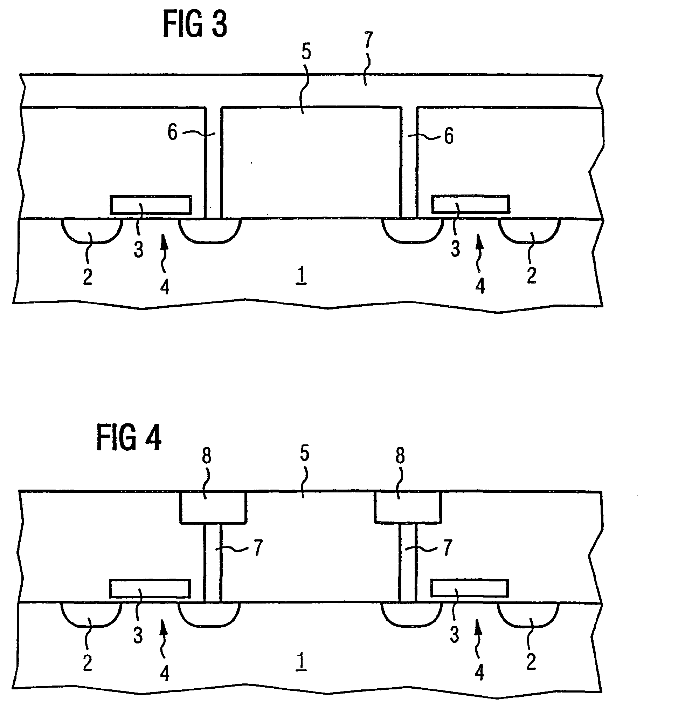

Dies kann beispielsweise durch ein CVD-Verfahren geschehen. Durch das Aufbringen des leitfähigen Materials 7 werden die Kontaktlöcher 6 vollständig ausgefüllt und es entsteht eine zusammenhängende leitfähige Schicht auf der isolierenden Schicht 5 (Fig. 3). Anschließend folgt ein CMP-Schritt ("Chemical Mechanical Polishing"), der die zusammenhängende leitfähige Schicht auf der Oberfläche der isolierenden Schicht 5 entfernt und eine ebene Oberfläche erzeugt.

Im weiteren werden Vertiefungen in der isolierenden Schicht 5 überlappend zu den Kontaktlöchern 6 oder nur in den Kontaktlöchern 6 gebildet. Als Alternative können Vertiefungen auch in einer weiteren isolierenden Schicht (nicht gezeigt) erzeugt werden, die nach der Strukturierung des leitfähigen Materials 7 auf die isolierende Schicht 5 abgeschieden wird.

Verfahrens abgeschlossen, d.h. ein vorstrukturiertes Substrat, auf dem im folgenden eine Metalloxidschicht abgeschieden und strukturiert wird, wurde bereitgestellt.

Diese Vertiefungen werden nun mit Barrierematerial 8, beispielsweise Iridium und/oder Iridiumoxid, bis zu einer vorgegebenen Höhe gefüllt. Dies geschieht, indem das Barrierematerial 8, beispielsweise mit Hilfe eines Sputterverfahrens, ganzflächig abgeschieden und mit einem CMP-Schritt bis zur Oberfläche der isolierenden Schicht 5 zurückpoliert wird. Zur Ausführung des CMP-Schritts wird eine Polierflüssigkeit eingesetzt, die polykristallines Diamantpulver als abrasive Partikel enthält. Damit ist das erfindungsgemäße Verfahren abgeschlossen. Es wurde eine Metall- und/oder Metalloxidschicht zur Bildung der Barrieren 8 strukturiert. Die sich daraus ergebende Struktur ist in Fig. 4 gezeigt.

Im folgenden bildet die in Fig. 4 gezeigte Struktur den Ausgangspunkt für die nochmalige Anwendung eines erfindungsgemäßen Verfahrens. Dazu wird eine Maskenschicht aus isolierendem Material, z.B. aus Siliziumoxid, aufgebracht und durch einen photolithographischen Schritt so strukturiert, dass sie im Bereich um die Kontaktlöcher geöffnet wird. Die geöffneten Bereiche der Maske 9 legen die Geometrie der unteren Elektroden fest.

Damit ist wiederum der erste Schritt a) des erfindungsgemäßen Verfahrens abgeschlossen, d.h. ein vorstrukturiertes Substrat, auf dem im folgenden eine Metallschicht abgeschieden und strukturiert wird, wurde bereitgestellt.

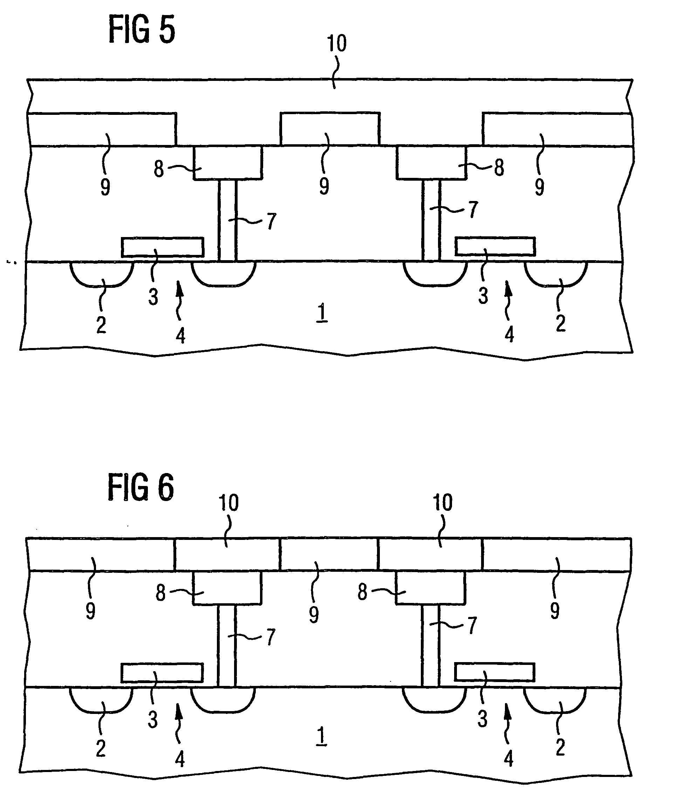

Auf die Siliziumoxid-Maske 9 wird nun eine Metallschicht 10, beispielsweise eine Pt-Schicht, abgeschieden. Die Dicke der leitenden Schicht ist dabei so gewählt, dass die Öffnungen in der Siliziumoxid-Maske 9 vollständig aufgefüllt werden. Die sich daraus ergebende Struktur ist in Fig. 5 gezeigt.

In einem anschließenden CMP-Schritt wird die zusammenhängende Pt-Schicht 10 auf der Oberfläche der Siliziumoxid-Maske 9 entfernt und eine ebene Oberfläche erzeugt. Zur Ausführung des CMP-Schritts wird eine Polierflüssigkeit eingesetzt, wie sie in den folgenden Ausführungsbeispielen beschrieben ist. Die sich daraus ergebende Struktur ist in Fig. 6 gezeigt.

Die durch die Strukturierung der Pt-Schicht 10 entstandenen Elektroden, bilden die unteren Elektroden der noch zu erzeugenden Speicherkondensatoren. Zu deren Fertigstellung müssen noch eine dielektrische/ferroelektrische Schicht sowie eine weitere Elektrodenschicht abgeschieden und strukturiert werden. Dabei kann zur Strukturierung der oberen Elektrode wiederum ein erfindungsgemäßes Verfahren eingesetzt werden.

Ausführungsbeispiel 1

Es wurde eine Platinoberfläche mit einer Polierflüssigkeit wässrige Suspension enthaltend polykristallines, synthetisches Diamantpulver mit einer Partikelgröße von etwa 1 μm) behandelt. Der Polierdruck wurde auf 6,9 kPa (1 psi) eingestellt. Die Rotationsgeschwindigkeit der Polierscheibe betrug 20 (rpm).
Nach einer Polierzeit von 5 min betrug die Oberflächenrauhigkeit der Platinoberfläche 3,5 nm (rms, gemessen nach der Analysenmethode AFM) bei einer maximalen Kratzertiefe von 20 nm. Die Abtragsrate lag unter den vorstehend beschriebenen Bedingungen bei 10 nm/min.

Ausführungsbeispiel 2

Es wurde eine Platinoberfläche mit einer Polierflüssigkeit (Heraeus Kulzer Technotron-Diamantflüssigkeit MM 140, enthaltend polykristalline Diamantpartikel mit einer Größe von etwa 1 μm und 25-50 Vol.-% weißen Spiritus, 0-5 Vol.-% Ethandiol und als Rest Wasser) und einem Oxidationsmittel (5 Gew.-% $KClO_3$-Lösung) behandelt. Das Verhältnis Diamantsuspension zu $KClO_3$-Lösung war 5:1.
Der Polierdruck wurde auf 13,8 kPa (2 psi) eingestellt.

Die Rotationsgeschwindigkeit der Polierscheibe betrug 30 rpm. Nach einer Polierzeit von 3 min konnte eine Abtragsrate von 52 nm/min festgestellt werden.

Ausführungsbeispiel 3

Eine Platinoberfläche wurde mit der in Ausführungsbeispiel 2 verwendeten Polierflüssigkeit bearbeitet, wobei als Oxidationsmittel im vorliegenden Beispiel ein Gemisch aus einer 10 Gew.-% $Na_2S_2O_8$-Lösung und einer 0,1 Gew.-% $AgNO_3$-Lösung verwendet wurden. Das Verhältnis Diamantsuspension zu $Na_2S_2O_8$/$AgNO_3$-Lösung war 3:1. Der Polierdruck wurde auf 13,8 kPa (2 psi) eingestellt. Die Rotationsgeschwindigkeit der Polierscheibe lag bei 30 rpm.
Die Abtragsrate betrug nach einer Polierzeit von 3 min 29 nm/min.

Ausführungsbeispiel 4

Eine Platinoberfläche wurde mit einer wässrigen Diamantsuspension enthaltend polykristalline Diamantpartikel mit einer Größe von etwa 0,1 μm (Masterprep Polishing Suspension von Bühler) bearbeitet. Der Polierdruck wurde auf 6,9 kPa (1 psi) eingestellt. Die Rotationsgeschwindigkeit der Polierscheibe lag bei 30 rpm.
Nach einer Polierzeit von 3 min konnte eine Abtragsrate von 6 nm/min festgestellt werden.

Ausführungsbeispiel 5

Eine Platinoberfläche wurde mit einer wässrigen Diamantsuspension enthaltend polykristalline Diamantpartikel mit einer Größe von etwa 0,05 μm (Masterprep Polishing Suspension von Bühler) bearbeitet. Der Polierdruck wurde auf 6,9 kPa (1 psi) eingestellt. Die Rotationsgeschwindigkeit der Polierscheibe betrug 30 rpm.
Nach einer Polierzeit von 3 min konnte eine Abtragsrate von 2 nm/min festgestellt werden.

**Patentansprüche**

1. Polierflüssigkeit, insbesondere für das Abtragen und/oder Strukturieren von Metalloxiden und Metallen, insbesondere Elementen der Gruppe 8b des Periodensystems, durch chemisch-mechanisches Polieren, enthaltend

   a) Wasser oder ein Wasser/Alkoholgemisch,

   b) polykristallines Diamantpulver, und

   c) zumindest ein Additiv ausgewählt aus der Gruppe Oxidationsmittel, Komplexbildner, Tensid und organische Base.

**2.** Polierflüssigkeit nach Anspruch 1,
**dadurch gekennzeichnet, dass**
die Größe der Partikel des polykristallinen Diamantpulvers kleiner als etwa 1 µm ist.

**3.** Polierflüssigkeit nach Anspruch 2,
**dadurch gekennzeichnet, dass**
die Größe der Partikel des polykristallinen Diamantpulvers zwischen 0,05 und 1 µm, insbesondere zwischen 0,1 und 1 µm, liegt.

**4.** Polierflüssigkeit nach einem der Ansprüche 1 bis 3,
**dadurch gekennzeichnet, dass**
der Anteil des polykristallinen Diamantpulvers in der Polierflüssigkeit zwischen 1 und 30 Gewichtsprozent beträgt.

**5.** Polierflüssigkeit nach einem der Ansprüche 1 bis 4,
**dadurch gekennzeichnet, dass**
das polykristalline Diamantpulver ein synthetisches Diamantpulver ist.

**6.** Polierflüssigkeit nach einem der Ansprüche 1 bis 5,
**dadurch gekennzeichnet, dass**
das Additiv mindestens ein Oxidationsmittel, ausgewählt aus der Gruppe Sauerstoff, Ozon ($O_3$), Wasserstoffperoxid ($H_2O_2$), Peroxodisulfat in saurer oder alkalischer Lösung, Chlor-Sauerstoffverbindungen wie z.B. Hypochlorit, Chlorat und Perchlorat, Brom-Sauerstoffverbindungen wie z.B. Bromat, Jod-Sauerstoffverbindungen wie z.B. Jodat, Mangan-Sauerstoffverbindungen wie z.B. Permanganat, Chrom-Sauerstoffverbindungen wie z. B. Chromat, Eisen(III)-Verbindungen wie z.B. $Fe_2(SO_4)$, $K_3Fe(CN)_6$ und $Fe(A)_3$ mit A = F, Cl, Br, J oder ($NO_3$), Cer(IV)-Verbindungen wie z.B. Ce ($SO_4)_2$ und $Ce(NO_3)_4$, Königswasser und Chromschwefelsäure, ist, wobei die Oxidationsmittel allein oder in Kombination einsetzbar sind.

**7.** Polierflüssigkeit nach einem der Ansprüche 1 bis 6,
**dadurch gekennzeichnet, dass**
das Additiv mindestens ein Komplexbildner, ausgewählt aus der Gruppe Ethylendiamintetraessigsäure (EDTA), stickstoffhaltige Kronenether, Zitronensäure, Chloridliganden, Bromidliganden, Cyanidliganden und metallorganische Koordinationsverbindungen auf der Basis von Phosphinliganden ($PR_3$, wobei R einen organischen Rest darstellt) ist.

**8.** Polierflüssigkeit nach Anspruch 7,
**dadurch gekennzeichnet, dass**
der stickstoffhaltige Kronenether ein 1,4,8,11-Tetraazacyclotetradecan-Derivat ist.

**9.** Verfahren zur Planarisisierung und/oder Strukturierung einer Metalloxidschicht oder einer Metallschicht, enthaltend Metalle der Gruppe 8b des Periodensystems, mit den folgenden Schritten:

a) ein Substrat wird bereitgestellt,

b) eine Metalloxidschicht oder eine Metallschicht enthaltend Metalle der Gruppe 8b des Periodensystems wird aufgebracht,

c) eine Polierflüssigkeit enthaltend polykristallines Diamantpulver wird bereitgestellt, und

d) die Metalloxidschicht oder die Metallschicht wird durch einen Polierschritt mit Hilfe der Polierflüssigkeit planarisiert und/oder strukturiert.

**10.** Verfahren nach Anspruch 9,
**dadurch gekennzeichnet, dass**
die Größe der Partikel des polykristallinen Diamantpulvers kleiner als etwa 1 µ m ist.

**11.** Verfahren nach Anspruch 10,
**dadurch gekennzeichnet, dass**
die Größe der Partikel des polykristallinen Diamantpulvers zwischen 0,05 und 1 µm liegt.

**12.** Verfahren nach einem der Ansprüche 9 bis 11,
**dadurch gekennzeichnet, dass**
der Anteil des polykristallinen Diamantpulvers in der Polierflüssigkeit zwischen 1 und 30 Gewichtsprozent beträgt.

**13.** Verfahren nach einem der Ansprüche 9 bis 12,
**dadurch gekennzeichnet, dass**
das polykristalline Diamantpulver ein synthetisches Diamantpulver ist.

**14.** Verfahren nach einem der Ansprüche 9 bis 13,
**dadurch gekennzeichnet, dass**
die Polierflüssigkeit mindestens ein Additiv gemäß einem der Ansprüche 6 bis 8 enthält.

## FIG 1

## FIG 2

FIG 3

FIG 4

FIG 5

FIG 6

Europäisches
Patentamt

**EUROPÄISCHER RECHERCHENBERICHT**

Nummer der Anmeldung

EP 01 11 1686

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | DATABASE WPI<br>Section Ch, Week 199441<br>Derwent Publications Ltd., London, GB;<br>Class G02, AN 1994-333155<br>XP002174930<br>& WO 94 22970 A (ALTAI SCI PRODN ASSOC),<br>13. Oktober 1994 (1994-10-13)<br>* Zusammenfassung * | 1-6,9-14 | C09G1/02 |
| A | WO 99 64527 A (RODEL HOLDINGS INC)<br>16. Dezember 1999 (1999-12-16)<br>* Seite 5, Zeile 34 - Seite 6, Zeile 4 *<br>* Seite 6, Zeile 9-16 *<br>* Seite 6, Zeile 21 * | 1,6,7,9,<br>14 | |
| A | US 5 855 633 A (LEITTEN MICHAEL E ET AL)<br>5. Januar 1999 (1999-01-05) | | |

**RECHERCHIERTE SACHGEBIETE (Int.Cl.7)**

C09G
H01L
C09K

Der vorliegende Recherchenbericht wurde für alle Patentansprüche erstellt

| Recherchenort | Abschlußdatum der Recherche | Prüfer |
|---|---|---|
| DEN HAAG | 15. August 2001 | Miller, A |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 01 11 1686

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-08-2001

| Im Recherchenbericht angeführtes Patentdokument | | Datum der Veröffentlichung | Mitglied(er) der Patentfamilie | | Datum der Veröffentlichung |
|---|---|---|---|---|---|
| WO 9422970 | A | 13-10-1994 | RU | 2034889 C | 10-05-1995 |
| WO 9964527 | A | 16-12-1999 | EP | 1102821 A | 30-05-2001 |
| US 5855633 | A | 05-01-1999 | KEINE | | |

EPO FORM P0461

Für nähere Einzelheiten zu diesem Anhang : siehe Amtsblatt des Europäischen Patentamts, Nr.12/82